# FASCICULE DE BREVET EUROPEEN

(11) **EP 1 968 106 B1**
(45) Date de publication et mention de la délivrance du brevet: **11.12.2013**
(21) Numéro de dépôt: 08102226.1
(22) Date de dépôt: 03.03.2008
(51) Int. Cl.: H01L 21/336, H01L 29/786, H01L 29/08, H01L 21/28, H01L 29/66

(54) **Procédé de fabrication d'un transistor à effet de champ à grilles auto-alignées**
Herstellungsverfahren eines Feldeffekttransistors mit selbstjustierten Gates
Method of manufacturing a field-effect transistor with self-aligned gates

(30) Priorité: 09.03.2007 FR 0753740
(43) Date de publication de la demande: 10.09.2008
(73) Titulaire: Commissariat à l'Énergie Atomique et aux Énergies Alternatives, 75015 Paris (FR)
(72) Inventeur: Previtali, Bernard, 38100 Grenoble (FR)
(74) Mandataire: Ilgart, Jean-Christophe

(56) Documents cités:
- DE-A1- 19 928 564
- US-A- 5 583 362
- US-A- 5 773 331
- US-A1- 2005 282 318
- US-A1- 2006 270 164
- US-B2- 7 022 562
- ALLIBERT F ET AL: "Characterization of ultra-thin SOI films for double-gate MOSFETs", 2002 IEEE INTERNATIONAL SOI CONFERENCE PROCEEDINGS. WILLIAMSBURG, VA, OCT. 7 - 10, 2002, IEEE INTERNATIONAL SOI CONFERENCE, NEW YORK, NY : IEEE, US, 7 octobre 2002 (2002-10-07), pages 187-188, XP010611057, ISBN: 0-7803-7439-8

## Description

### DOMAINE TECHNIQUE

L'invention concerne un procédé de fabrication d'un transistor à effet de champ à double grilles, les grilles étant auto-alignées et horizontales.

### ÉTAT DE LA TECHNIQUE ANTÉRIEURE

Le document FR-A-2 829 294 (correspondant au brevet US 7 022 562) divulgue un transistor à effet de champ à grilles auto-alignées horizontales et son procédé de fabrication. Ce transistor comprend une région active formant un canal, une première grille isolée associée à une première face de la région active, des régions de source et de drain formées dans une partie de la région active, de part et d'autre du canal et auto-alignées sur la première grille, une deuxième grille isolée associée à une deuxième face de la région active, opposée à la première face de la région active.

Le procédé de réalisation de ce transistor comprend les étapes suivantes :
- la formation d'un empilement de couches comprenant à partir d'un substrat de support : une première couche de grille, une couche d'isolant de grille, une couche active, une deuxième couche d'isolant de grille et une deuxième couche de grille,
- la définition d'une grille, dite grille supérieure, dans la deuxième couche de grille,
- la formation dans la couche active de régions de source et de drain auto-alignées sur la grille supérieure, et
- la formation d'une grille, dite inférieure, disposée entre le substrat de support et la couche active, la grille inférieure étant formée de façon auto-alignée sur la grille supérieure.

La grille supérieure sert de masque à la réalisation du canal et de la grille inférieure, un jeu de multiples espaceurs venant protéger la grille supérieure lors de la gravure du canal (premier espaceur), le canal lors de la gravure de la grille inférieure (deuxième espaceur) et pour isoler la grille inférieure des régions de source et de drain (troisième espaceur).

Ce procédé de réalisation présente plusieurs inconvénients. La grille et ses protections (masque dur et espaceurs) subissent de multiples gravures. L'accès au canal nécessite le retrait du deuxième espaceur sélectivement par rapport aux premier et troisième espaceurs. Cette approche impose des régions de source et de drain qui ne sont pas en silicium cristallin. Usuellement, les régions de source et de drain sont métalliques. Elles sont obtenues par la formation et le remplissage d'une cavité isolante par un métal. L'empilement de grilles sert à séparer, par polissage mécano-chimique, la source du drain.

Le document US 2006/0022264 divulgue un procédé de fabrication d'un dispositif semiconducteur à double grille, les grilles étant auto-alignées. Le procédé de fabrication de ce transistor comporte l'utilisation d'une première grille (ou grille avant) et de ses espaceurs comme masque de gravure du canal et d'une couche de SiGe épitaxiée sur un substrat massif par en Si ou en Ge. Après collage et retournement, on réalise une grille avant de type damascène.

Le document US 2006/0027881 divulgue un procédé de fabrication d'un transistor à effet de champ à double grille, dans lequel on utilise la grille avant et une épitaxie de type source et drain pour former, sous le canal et la grille, une zone éliminée après collage et retournement pour accueillir la grille avant.

Les deux documents ci-dessus (US 2006/0022264) et US 2006/0027881) divulguent des procédés qui ont pour inconvénient de se servir du canal comme couche d'arrêt de gravure des espaceurs internes alors que le canal est une zone sensible à toute pollution. Un autre inconvénient inhérent à ces procédés est que les capacités présentes entre la grille avant et la source et entre la grille avant et le drain peuvent nuire au fonctionnement du dispositif obtenu.

Le document US 2005/0282318 divulgue un transistor à effet de champ à double grille et son procédé de fabrication.

### EXPOSÉ DE L'INVENTION

Pour remédier aux inconvénients de l'art antérieur, la présente invention propose un procédé permettant de ne graver que la partie nécessaire du canal du transistor à effet de champ et de former la grille arrière en conservant les zones de source et de drain en matériau semiconducteur monocristallin.

L'invention a donc pour objet un procédé de fabrication d'au moins une structure pour transistor à effet de champ à double grille, comprenant les étapes consistant à :
- former, sur une face isolante d'un premier substrat, un empilement comprenant successivement au moins une couche de matériau de grille arrière, une couche d'isolant électrique de grille arrière, une zone semiconductrice par structure à fabriquer, une couche d'isolant électrique de grille avant, au moins une couche de matériau de grille avant et un élément de masquage, par structure à fabriquer, disposé en regard de la zone semiconductrice,
- former dans la couche de matériau de grille avant un motif reproduisant la forme de l'élément de masquage et comprenant la gravure de la couche de matériau de grille avant pour éliminer le matériau de grille avant en dehors dudit motif,
- former sur les faces libres du motif un espaceur sacrificiel recouvrant une première partie de la zone semiconductrice et éliminer la partie exposée de la couche d'isolant électrique de grille avant, révélant ainsi la partie restante, ou deuxième partie, de la zone semiconductrice, destinée à la constitution des régions de source et de drain de transistor,
- former une couche de protection sur la partie restante, ou deuxième partie, de la zone semiconductrice,
- éliminer l'espaceur sacrificiel recouvrant ladite première partie de la zone semiconductrice,
- graver la première partie de la zone semiconductrice, qui n'est plus recouverte par l'espaceur sacrificiel, pour délimiter le canal du transistor.

L'étape de formation de l'empilement peut comprendre les étapes consistant à :
- choisir un deuxième substrat du type semiconducteur sur isolant, c'est-à-dire un substrat comprenant un support supportant successivement une couche électriquement isolante et une couche semiconductrice destinée à fournir ladite zone semiconductrice,
- former, sur ladite couche semiconductrice, ladite couche d'isolant électrique de grille arrière et ladite au moins une couche de matériau de grille arrière,
- fixer le deuxième substrat sur le premier substrat, lesdites couches formées sur le deuxième substrat étant en regard d'une face électriquement isolante du premier substrat,
- éliminer le support et la couche électriquement isolante du deuxième substrat pour révéler la couche semiconductrice,
- graver la couche semiconductrice pour obtenir ladite zone semiconductrice et révéler la couche d'isolant électrique de grille arrière,
- former successivement sur ladite zone semiconductrice et la couche d'isolant électrique de grille arrière révélée à l'étape de gravure une couche d'isolant électrique de grille avant, au moins une couche de matériau de grille avant et une couche de masquage,
- graver la couche de masquage pour obtenir ledit élément de masquage.

Dans ce cas, une couche électriquement isolante peut être également formée sur ladite au moins une couche de matériau de grille arrière pour servir de couche de collage, lors de la fixation du deuxième substrat sur le premier substrat, avec la face électriquement isolante du premier substrat qui est une face libre d'une couche électriquement isolante du premier substrat et formant également une couche de collage.

Selon un premier mode de réalisation, l'étape consistant à former un motif dans la couche de matériau de grille avant comprend une étape de gravure anisotrope permettant d'éliminer le matériau de grille avant en dehors du motif, une étape de gravure isotrope permettant de réduire la longueur de la grille avant et de former des logements pour des espaceurs de grille avant sous l'élément de masquage, et une étape de formation d'espaceurs de grille avant dans lesdits logements. La formation d'espaceurs de grille avant peut alors être réalisée par dépôt d'une couche de matériau d'espaceurs de grille avant et par gravure anisotrope de la couche de matériau d'espaceurs de grille avant.

Le procédé peut alors comprendre en outre les étapes consistant à :
- graver la couche d'isolant électrique de grille arrière exposée après la gravure de la première partie de la zone semiconductrice,
- éliminer ladite couche de protection,
- graver ladite au moins une couche de matériau de grille arrière non masquée par les parties non gravées de la couche d'isolant électrique de grille arrière, jusqu'à atteindre ladite face isolante du premier substrat,
- réduire, au moyen d'une gravure isotrope, la longueur des parties subsistantes de ladite au moins une couche de matériau de grille arrière, formant ainsi des logements pour des espaceurs de grille arrière,
- former des espaceurs de grille arrière dans lesdits logements d'espaceurs de grille arrière,
- épitaxier, à partir de la partie restante, ou deuxième partie, de la zone semiconductrice, des zones de raccordement au canal du transistor pour constituer les régions de source et de drain.

Selon un deuxième mode de réalisation, l'étape consistant à former un motif dans la couche de matériau de grille avant comprend une étape de gravure anisotrope permettant d'éliminer le matériau de grille avant en dehors du motif.

Le procédé peut alors comprendre en outre les étapes consistant à :
- graver la couche d'isolant électrique de grille arrière exposée après la gravure de la première partie de la zone semiconductrice,
- éliminer ladite couche de protection,
- graver ladite au moins une couche de matériau de grille arrière non masquée par les parties non gravées de la couche d'isolant électrique de grille arrière, jusqu'à atteindre ladite face isolante du premier substrat,
- réduire, au moyen d'une gravure isotrope, la longueur des parties subsistantes de ladite au moins une couche de matériau de grille avant et de ladite au moins une couche de matériau de grille arrière, formant ainsi des logements pour des espaceurs de grille avant et des logements pour des espaceurs de grille arrière,
- former des espaceurs de grille avant dans les logements d'espaceurs de grille avant et des espaceurs de grille arrière dans les logements d'espaceurs de grille arrière,
- épitaxier, à partir de la partie restante, ou deuxième partie, de la zone semiconductrice, des zones de raccordement au canal du transistor pour constituer les régions de source et de drain.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels .
- les figures 1A à 1E illustrent des étapes préparatoires du procédé de fabrication d'un transistor à effet de champ à grilles auto-alignées selon l'invention,
- les figures 2A à 2J illustrent une première variante de la suite du procédé de fabrication d'un transistor à effet de champ à grilles auto-alignées selon l'invention,
- les figures 3A à 3I illustrent une seconde variante de la suite du procédé de fabrication d'un transistor à effet de champ à grilles auto-alignées selon l'invention.

### EXPOSÉ DÉTAILLÉ DE MODES DE RÉALISATION PARTICULIERS

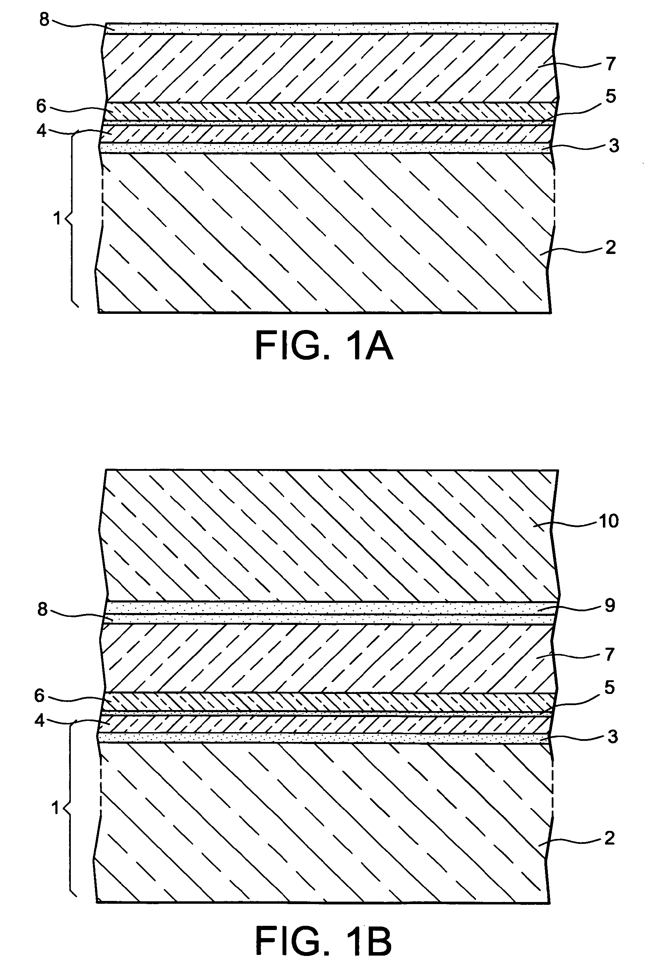

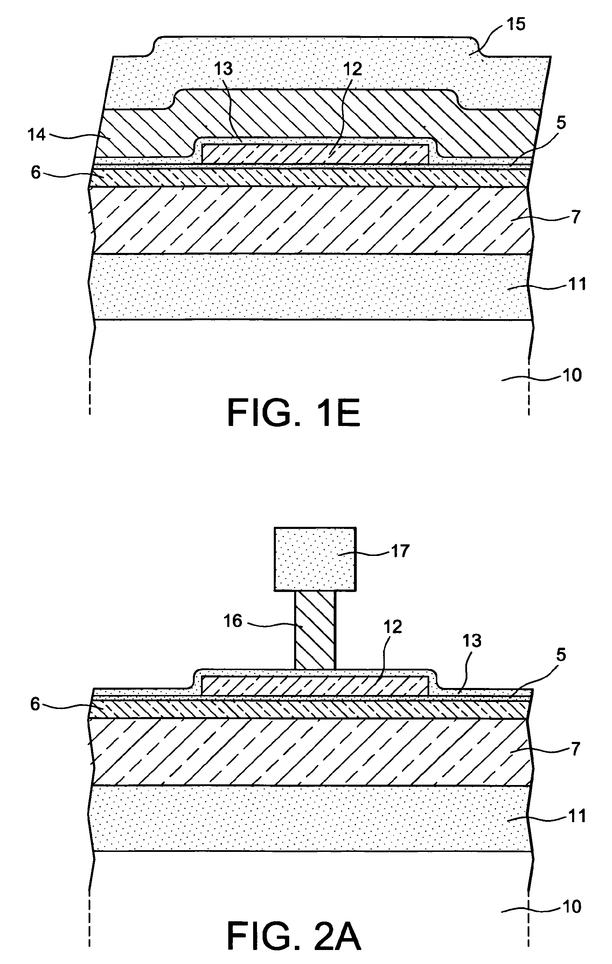

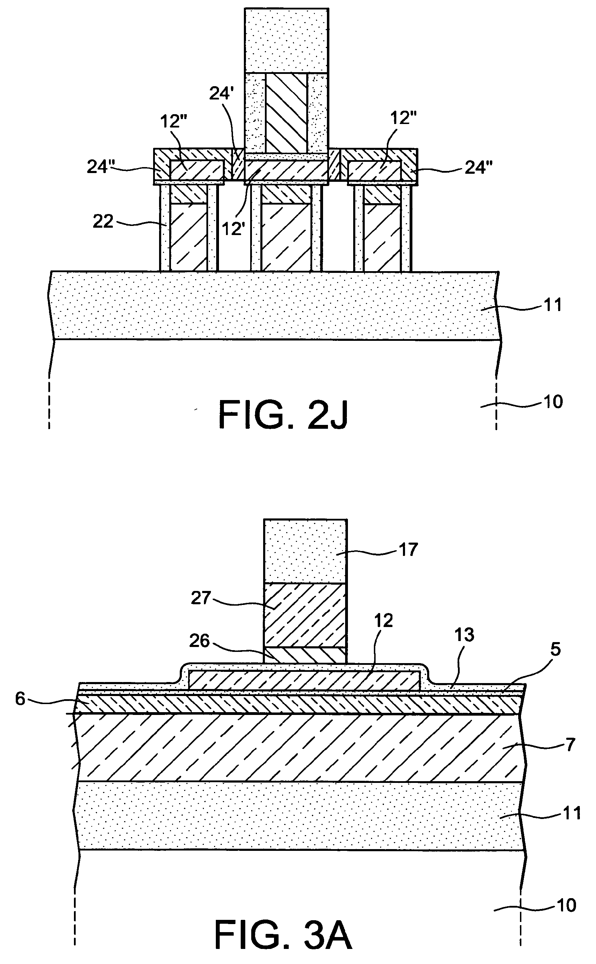

Les figures 1A à 1E illustrent des étapes préparatoires du procédé de fabrication d'un transistor à effet de champ à grilles auto-alignées selon l'invention. Le procédé peut ensuite être poursuivi selon une première variante illustrée par les figures 2A à 2J ou selon une deuxième variante illustrée par les figures 3A à 3I.

La figure 1A montre un substrat du type semiconducteur-sur-isolant 1, à titre d'exemple un substrat SOI comprenant un support 2 en silicium supportant une couche 3 d'oxyde de silicium et une couche 4 de silicium. Ce substrat pourrait aussi être choisi parmi les substrats SS0I (Silicium contraint sur isolant) et GeOI, avec un isolant qui peut être du Si0₂ ou du nitrure de silicium. Sur la couche de silicium 4, on dépose successivement une couche isolante 5, une première couche 6 de matériau de grille arrière, une deuxième couche 7 de matériau de grille arrière et une couche de collage 8 par exemple en oxyde de silicium.

Si la couche 4 est en silicium, la couche isolante 5 est avantageusement en oxyde de silicium. Elle fournira l'isolant de grille arrière. Les matériaux de grille arrière sont sélectionnés pour leur chimie de gravure différente de celle du matériau de zone active. Dans le cas de zones actives en silicium (fournies par la couche 4), le matériau de la couche 6 peut être en TiN et celui de la couche 7 en SiGe ou en polysilicium dopé pour obtenir une bonne sélectivité par rapport au silicium. Le SiGe ou le polysilicium n'ont, dans cet exemple de réalisation, que pour fonction de mettre la grille sous tension (rôle de shunt), le véritable matériau de grille étant le TiN. Le matériau de grille arrière (matériau de la couche 6) peut également être en W_{y}Siₓ ou en alliage TiNSi ou encore en TaN.

La structure représentée à la figure 1A est reportée et collée sur un substrat massif. Ce substrat massif est par exemple en silicium oxydé en surface. La figure 1B montre la structure obtenue précédemment collée sur le substrat massif 10, de sorte que la couche de collage 8 est en contact intime avec la couche d'oxyde 9 du substrat massif 10. Si les couches 8 et 9 sont en oxyde de silicium, le collage peut être avantageusement obtenu par adhésion moléculaire (ou « wafer bonding » dans la terminologie anglo-saxonne), technique bien connue de l'homme de l'art.

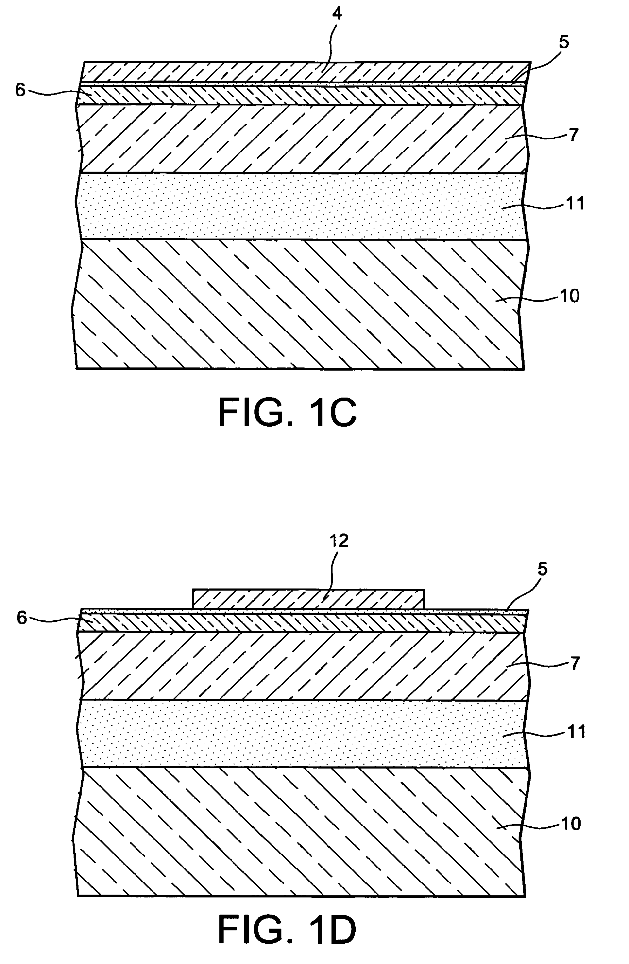

Le support 2 et la couche d'oxyde 3 du substrat SOI 1 sont ensuite retirés par exemple à l'aide d'un polissage suivi d'une attaque chimique ou par une autre technique connue de l'homme de l'art. La figure 1C représente la structure obtenue après retournement. Sur cette figure, les couches d'oxyde en contact intime (référencées 8 et 9 sur la figure 1B) sont représentées sous la forme d'une couche unique d'oxyde 11. La structure présente alors une couche supérieure 4 en silicium, constituée de la couche mince du substrat SOI 1.

L'étape suivante consiste à former des zones actives de transistors et d'autres composants dans la couche de silicium 4. Par souci de simplification, la suite de la description ne portera que sur la réalisation d'un seul transistor à effet de champ à double grilles. La largeur du transistor à réaliser sera définie par lithographie et gravure de la couche de silicium 4 avec arrêt sur la couche d'isolant de grille arrière 5. La figure 1D montre une zone active 12 de transistor ainsi réalisée.

Sur la structure obtenue on dépose ensuite successivement, comme le montre la figure 1E, une couche 13 d'isolant de grille avant et une couche 15 de masque dur. Les couches 13, 14 et 15 épousent le relief de la structure. La couche 13 d'isolant de grille avant peut être en HfO₂, en HfSiOₓ, en oxyde de silicium, en oxyde de silicium nitruré ou en oxyde de tantale. La couche 14 de matériau de grille avant peut être en alliage WSi. La couche 15 de masque dur peut être constituée d'un ou de plusieurs matériaux (nitrure sur oxyde, polysilicium sur oxyde, carbone amorphe, nitrure seul, etc...). Le masque dur sert à définir la longueur de la grille avant, notamment lors de la gravure isotrope. Il offre une bonne sélectivité de gravure par rapport au matériau de la grille avant. Il est peu sensible aux nettoyages nécessaires avant l'épitaxie du matériau de source et de drain.

Les figures 2A à 2J illustrent une première variante de la suite du procédé de fabrication d'un transistor à effet de champ à grilles auto-alignées selon l'invention. Cette variante s'applique au cas où les matériaux de grille avant et de grille arrière sont différents ou au cas où les chimies de gravure sont incompatibles.

Le masque dur et les espaceurs de grille avant ne sont pas nécessairement dans le même matériau. Les espaceurs ont un rôle électrique alors le masque dur ne sert qu'à protéger la grille avant lors des gravures suivantes : gravure isotrope de grille avant, gravure du canal, gravure anisotrope de grille arrière, gravure isotrope de grille arrière.

On procède à la lithographie et à la gravure du masque dur 15 (voir la figure 1E). Le masque dur 15 est gravé avec arrêt sur la couche de matériau de grille avant 14. La couche de matériau de grille avant 14 est ensuite gravée, avec arrêt sur la couche d'isolant de grille avant 13, d'abord en gravure anisotrope, puis en gravure isotrope pour réduire la longueur de la grille avant. On obtient la structure montré à la figure 2A où la référence 16 représente la grille avant du transistor et la référence 17 représente une partie subsistante du masque dur.

On dépose alors sur la structure obtenue une couche d'un matériau destiné à former les espaceurs de la grille avant. Cette couche est en un matériau peu sensible aux nettoyages nécessaires avant épitaxie, par exemple en nitrure de silicium. On peut cependant envisager des espaceurs et un masque dur en oxyde de silicium. Il convient alors de les dimensionner en prenant en compte leur diminution de cotes lors des opérations de nettoyages et gravures.

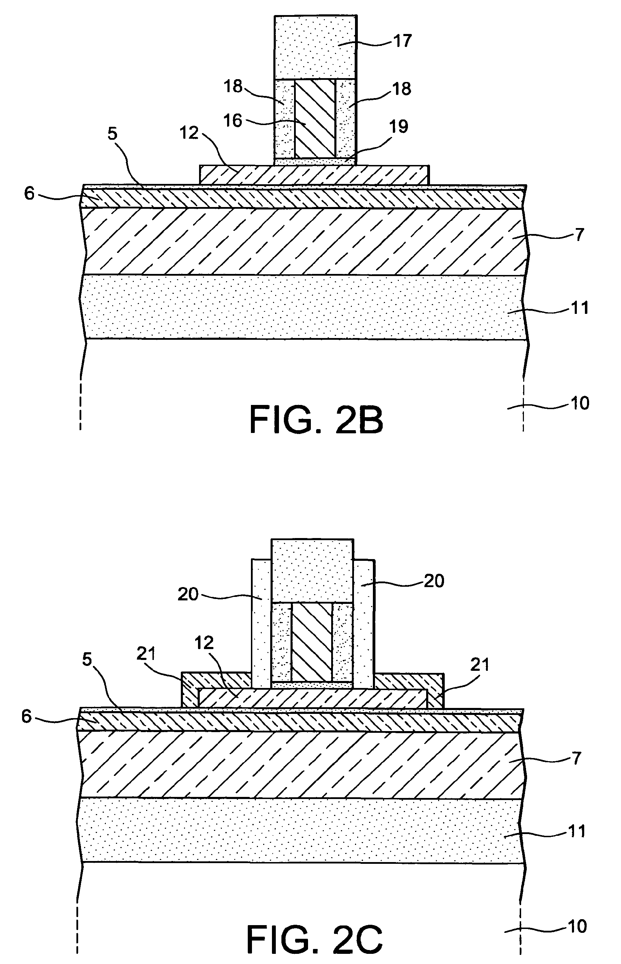

La couche de matériau d'espaceurs de la grille avant est gravée selon une technique de gravure anisotrope. La couche 13 d'isolant de grille avant est également gravée de manière à révéler la couche 5 d'isolant de grille arrière et la zone active 12 comme le montre la figure 2B. Cette figure montre également les espaceurs 18 de la grille avant 16 et l'isolant de grille avant 19. La grille avant 19 étant, après que la gravure des espaceurs 18, entièrement encapsulée, son matériau peut être différent du matériau de la grille arrière.

On forme ensuite des seconds espaceurs (ou espaceurs sacrificiels) dans un matériau différent des premiers espaceurs, par exemple en Si0₂ dans le cas où les premiers espaceurs sont en nitrure de silicium. Ces seconds espaceurs 20 (voir la figure 2C) sont obtenus par dépôt d'une couche et gravure anisotrope de cette couche jusqu'à ne conserver que les parties de la couche formant les seconds espaceurs. Les seconds espaceurs étant sacrificiels, leur retrait doit s'opérer sélectivement par rapport au masque dur, aux premiers espaceurs et à l'épitaxie du matériau de source et de drain. Le matériau de ces seconds espaceurs peut être, dans le cas d'un masque dur et de premiers espaceurs en oxyde de silicium, par exemple en nitrure de silicium. Dans un mode de réalisation avantageux, le masque dur et les espaceurs de grille avant sont en nitrure de silicium alors que les espaceurs sacrificiels sont en oxyde de silicium. Les espaceurs sacrificiels peuvent être multicouches (oxyde sur nitrure sur oxyde ou encore oxyde sur polysilicium sur oxyde) permettant la réalisation d'espaceurs en L.

Ensuite, on forme, à partir de la zone active 12, des régions épitaxiées 21. Les régions épitaxiées sont en SiGe si la zone active 12 est en silicium, en silicium si la zone active en SiGe ou en Ge, en Ge si la zone active est en SiGe ou Si. Cependant, on peut envisager que cette épitaxie soit dans le même matériau. Il en résultera une gravure du canal au temps avec le risque de voir la zone de source et de drain dégradée.

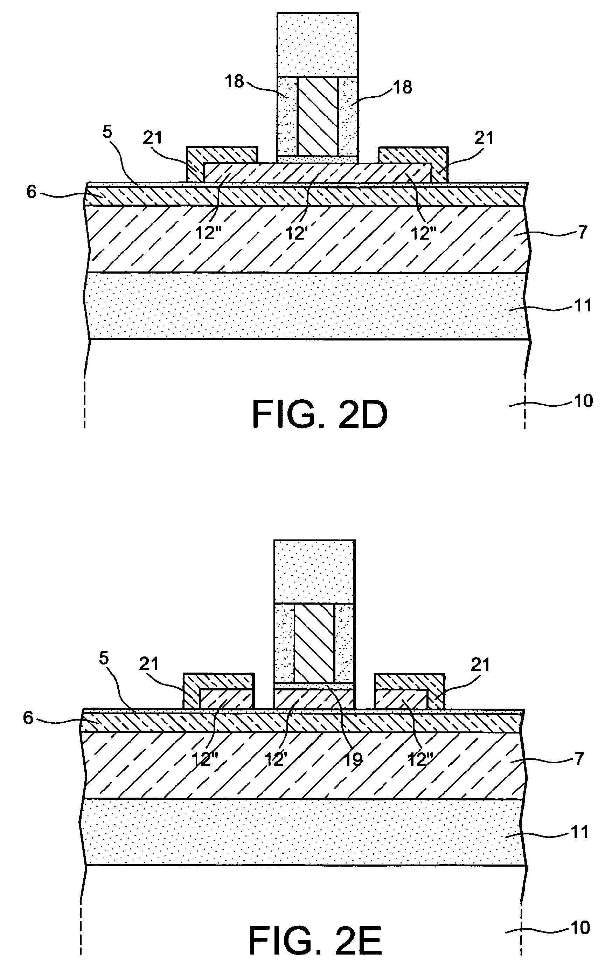

Les espaceurs sacrificiels sont ensuite éliminés par gravure comme le montre la figure 2D, exposant ainsi les premiers espaceurs 18 et la partie de la zone active 12 précédemment recouverte par les seconds espaceurs.

La zone active 12 en silicium est gravée sélectivement par rapport aux régions épitaxiées jusqu'à révéler la couche d'isolant de grille arrière 5, délimitant ainsi le canal 12' du transistor entre l'isolant de grille avant 19 et la couche d'isolant de grille arrière 5 (voir la figure 2E). Il subsiste aussi, sous les régions épitaxiées 21, des parties 12" de la zone active. Les parties 12", qui fourniront les zones de source et de drain, ne sont pas polluées par cette gravure.

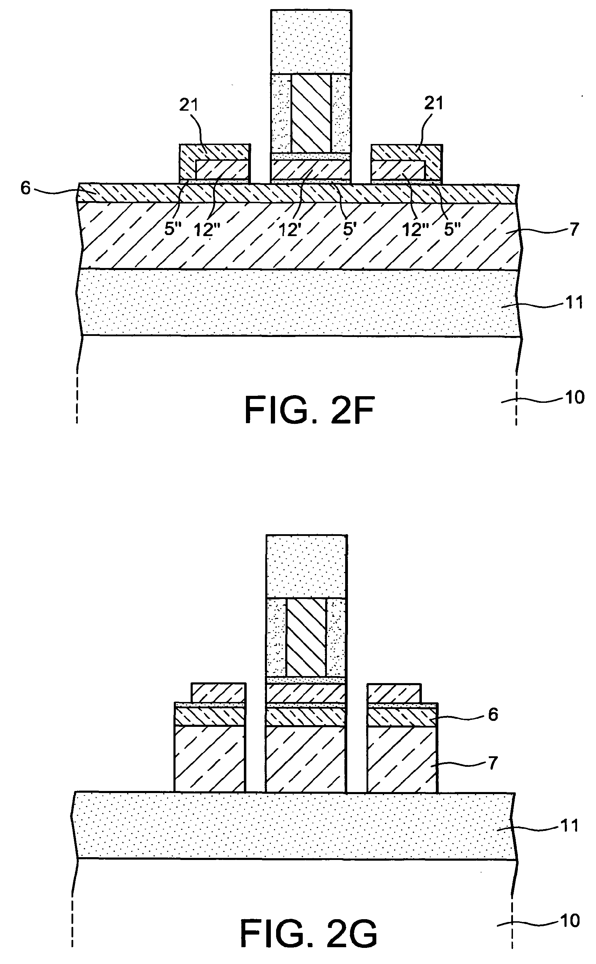

La couche d'isolant de grille arrière 5 est ensuite sélectivement gravée avec arrêt sur la couche 6 de matériau de grille arrière (voir la figure 2F). Il subsiste alors un isolant de grille arrière 5' sous le canal 12' et des parties 5" sous les parties de source et de drain 12" et 21.

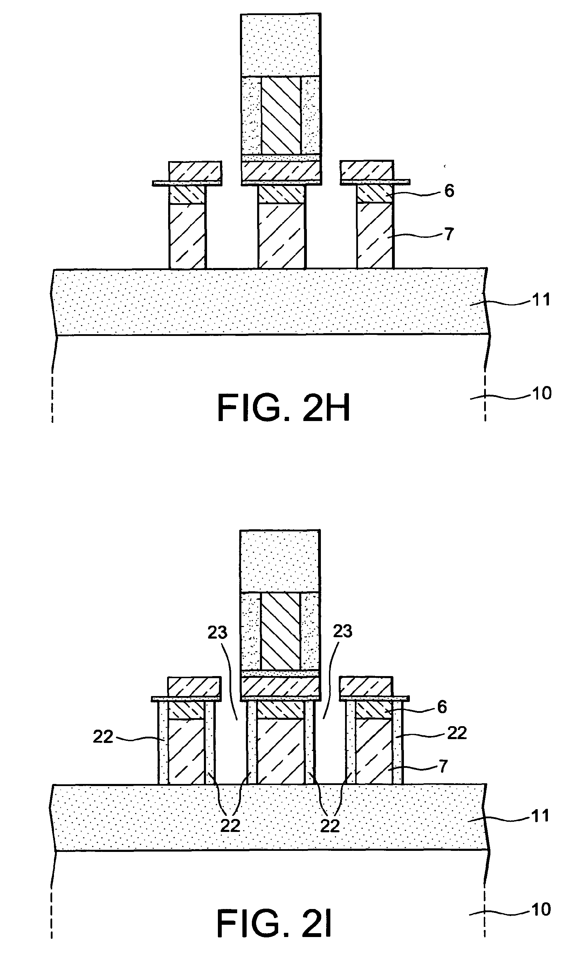

L'étape suivante consiste à graver la grille arrière. Pour cela, on grave successivement la première couche 6 de matériau de grille arrière et la deuxième couche 7 de matériau de grille arrière jusqu'à révéler la couche d'oxyde 11. La gravure des couches 6 et 7 est d'abord anisotrope (voir la figure 2G), puis isotrope (voir la figure 2H).

On forme ensuite les espaceurs sur les flancs de la grille arrière. Pour cela, une couche de nitrure de silicium est déposée sur la structure obtenue précédemment. Cette couche de nitrure est gravée en utilisant une technique de gravure anisotrope, puis une technique de gravure isotrope pour conserver des espaceurs 22 sur les parties subsistantes des couches 6 et 7 de grille arrière et de support de drain et de source (voir la figure 2I). Les tranchées 23 formées entre la grille arrière et les zones de source et de drain peuvent être comblées par dépôt d'oxyde organique et fluage de ce matériau.

Une étape d'épitaxie est ensuite réalisée afin de raccorder le canal 12' aux régions de source et de drain 12". La figure 2J montre la zone 24' épitaxiée à partir du canal 12' et les zones 24" épitaxiées à partir des parties 12" de source et de drain. Le matériau épitaxié peut être du Si, du SiGe ou du Ge.

La fin de l'assemblage étant standard dans la technologie CMOS, elle ne sera pas décrite.

Les figures 3A à 3I illustrent une seconde variante de la suite du procédé de fabrication d'un transistor à effet de champ à grilles auto-alignées selon l'invention. Cette variante s'applique au cas où les matériaux de grille avant et de grille arrière sont identiques.

La structure montrée à la figure 3A correspond à celle de la figure 2A. Sur ces figures, les mêmes références représentent les mêmes éléments. Contrairement à la structure de la figure 2A, la structure de la figure 3A possède des grilles avant et arrière en matériaux identiques. Ainsi, la grille avant du transistor comprend une partie 26 en un matériau identique à celui de la couche 6 (par exemple en TiN) et une partie 27 en un matériau identique à celui de la couche 7 (par exemple en SiGe). On remarque aussi sur la figure 3A que la grille avant 26, 27 n'a pas, à ce stade, encore été gravée de manière isotrope. En effet, dans cette variante il est judicieux d'effectuer la gravure isotrope des grilles en même temps afin de s'assurer qu'elles ont les mêmes dimensions. Les premiers espaceurs seront les espaceurs sacrificiels.

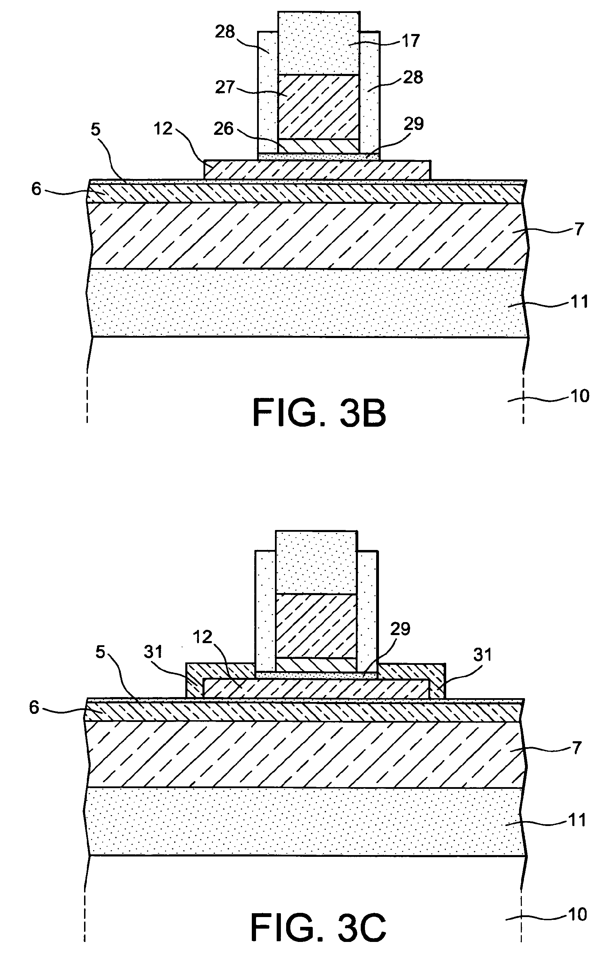

On dépose alors sur la structure obtenue une couche d'un matériau destiné à former les espaceurs de la grille avant, par exemple une couche d'oxyde de silicium. Cette couche est gravée selon une technique de gravure anisotrope. La couche 13 d'isolant de grille avant est également gravée de manière à révéler la couche 5 d'isolant de grille arrière et la zone active 12 comme le montre la figure 3B. Cette figure montre également les espaceurs 28 de la grille avant 26, 27 et l'isolant de grille avant 29.

On forme ensuite (voir la figure 3C), à partir de la zone active 12, des régions épitaxiées 31 par exemple en SiGe si la zone active 12 est en silicium. Les régions épitaxiées 31 recouvrent et protègent les parties de la zone active 12 qui étaient auparavant libres de revêtement.

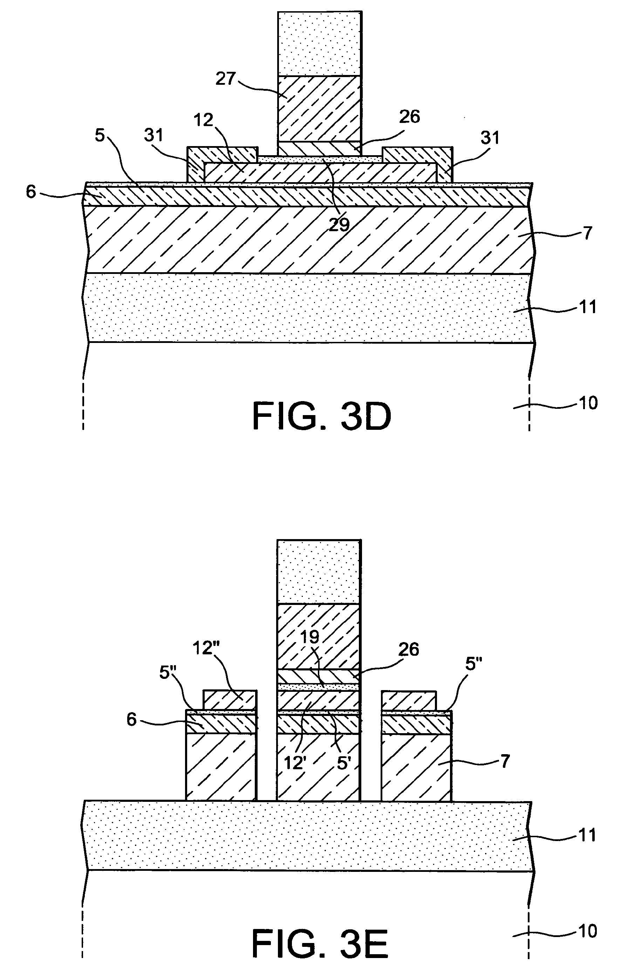

On procède ensuite au retrait des espaceurs sacrificiels jusqu'à révéler une partie de l'isolant de grille 29, comme le montre la figure 3D.

On procède ensuite à une étape de gravure de plusieurs matériaux. Les parties apparentes de l'isolant de grille 29, par exemple en Hf0₂, sont gravées. Il subsiste alors l'isolant de grille avant 19 et des parties de la zone active 12 sont révélées. On grave alors la zone active 12 pour délimiter le canal 12' du transistor entre l'isolant de grille avant 19 et la couche d'isolant de grille arrière. Il subsiste aussi, sous les régions épitaxiées, des parties 12" de la zone active. Les parties 12" ne sont pas polluées par cette gravure parce qu'elles sont alors encore recouvertes par les régions épitaxiées 31.

La gravure de la zone active révèle la couche 5 d'isolant de grille arrière, par exemple en HfO₂. Les parties apparentes de la couche 5 sont alors gravées. Il subsiste alors de cette couche, l'isolant de grille arrière 5' (masqué par le canal 12') et des parties 5" (masquées par les parties 12" de source et de drain et les régions épitaxiées 31).

On procède ensuite à la gravure anisotrope des parties non masquées de la première couche 6 de matériau de grille arrière et des parties non masquées de la deuxième couche 7 de matériau de grille arrière. La structure obtenue est montrée sur la figure 3E.

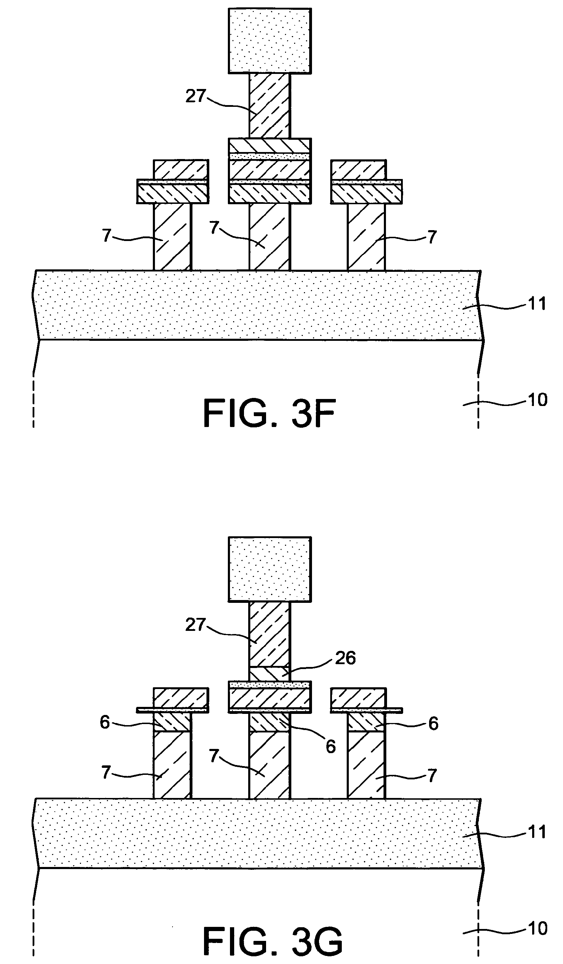

On procède ensuite à la gravure isotrope des grilles. Cette gravure se fait en deux temps. La figure 3F montre la structure obtenue après gravure des éléments en matériau identique, par exemple en SiGe, constitués par les parties subsistantes de la deuxième couche 7 de matériau de grille arrière et par la partie 27 de la grille avant. La figure 3G montre la structure obtenue après gravure des éléments en matériau identique, par exemple en TiN, constitués par les parties subsistante de la première couche 6 de matériau de grille arrière et par la partie 26 de la grille avant.

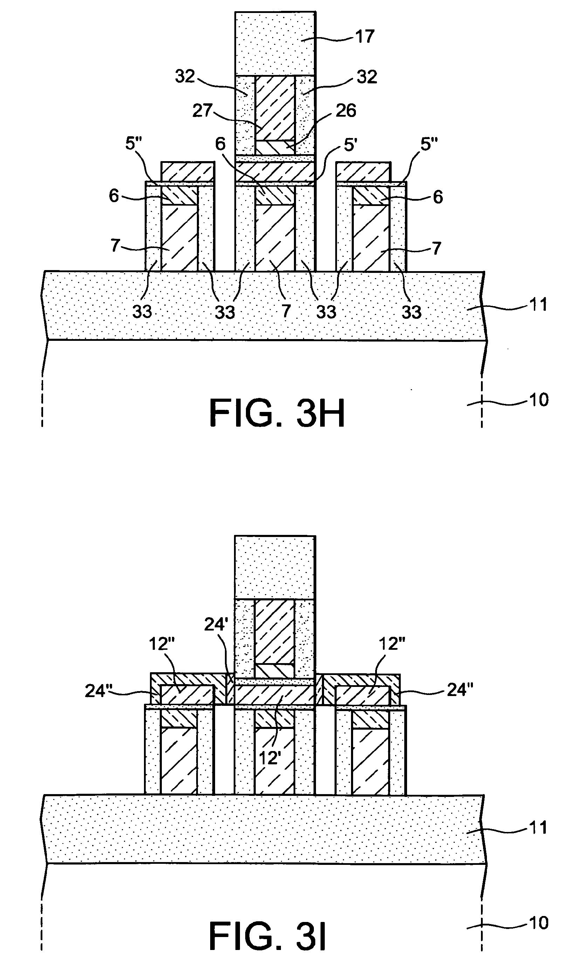

On forme ensuite les espaceurs sur les flancs des grilles avant et arrière. Pour cela, une couche de nitrure de silicium est déposée sur la structure obtenue précédemment. Cette couche de nitrure est gravée en utilisant une technique de gravure anisotrope pour conserver des espaceurs aux endroits désirés (voir la figure 3H). Ainsi, des espaceurs 32 sont formés sur les flancs de la grille avant 26, 27 et sous le surplomb que forme la partie 17 subsistante du masque dur. Des espaceurs 33 sont aussi formés sur les flancs des parties subsistantes des couches 6 et 7 de matériaux de grille arrière et sous les surplombs que forment l'isolant de grille arrière 5' et les parties 5".

Une étape d'épitaxie est ensuite réalisée afin de raccorder le canal 12' aux régions de source et de drain 12". La figure 3I montre la zone 24' épitaxiée à partir du canal 12' et les zones 24" épitaxiées à partir des parties 12" de source et de drain. Le matériau épitaxié peut être du Si, du SiGe ou du Ge.

Les grilles sont de type débordantes sur zone d'isolation, ce qui permet, avec un niveau de lithogravure supplémentaire de découpler les grilles lors de la réalisation des contacts électriques. La réalisation de ces contacts peut se faire par une technique bien connue de l'homme de l'art. La fin de l'assemblage est standard dans la technologie CMOS et ne sera donc pas décrite.

## Revendications

1. Procédé de fabrication d'au moins une structure pour transistor à effet de champ à double grille, comprenant les étapes consistant à :
- former, sur une face isolante (11) d'un premier substrat (10), un empilement comprenant successivement au moins une couche de matériau de grille arrière (6, 7), une couche d'isolant électrique de grille arrière (5), une zone semiconductrice par structure à fabriquer (4), une couche d'isolant électrique de grille avant (13), au moins une couche de matériau de grille avant (14) et un élément de masquage (17), par structure à fabriquer, disposé en regard de la zone semiconductrice,
- former dans la couche de matériau de grille avant un motif (16) reproduisant la forme de l'élément de masquage (17) et comprenant la gravure de la couche de matériau de grille avant pour éliminer le matériau de grille avant en dehors dudit motif,
- former sur les faces libres du motif un espaceur sacrificiel (20) recouvrant une première partie de la zone semiconductrice et éliminer la partie exposée de la couche d'isolant électrique de grille avant, révélant ainsi la partie restante, ou deuxième partie,
de la zone semiconductrice, destinée à la constitution des régions de source et de drain de transistor,
- former une couche de protection (21) sur la partie restante, ou deuxième partie, de la zone semiconductrice,
- éliminer l'espaceur sacrificiel recouvrant ladite première partie de la zone semiconductrice,
- graver la première partie de la zone semiconductrice, qui n'est plus recouverte par l'espaceur sacrificiel, pour délimiter le canal (12') du transistor.

2. Procédé selon la revendication 1, dans lequel l'étape de formation de l'empilement comprend les étapes consistant à :
- choisir un deuxième substrat (1) du type semiconducteur sur isolant, c'est-à-dire un substrat comprenant un support (2) supportant successivement une couche électriquement isolante (3) et une couche semiconductrice (4) destinée à fournir ladite zone semiconductrice,
- former, sur ladite couche semiconductrice (4), ladite couche d'isolant électrique de grille arrière (5) et ladite au moins une couche de matériau de grille arrière (6, 7),
- fixer le deuxième substrat sur le premier substrat (10), lesdites couches formées sur le deuxième substrat étant en regard d'une face électriquement isolante du premier substrat,
- éliminer le support (2) et la couche électriquement isolante (3) du deuxième substrat pour
révéler la couche semiconductrice (4),
- graver la couche semiconductrice (4) pour obtenir ladite zone semiconductrice (12) et révéler la couche d'isolant électrique (5) de grille arrière,
- former successivement sur ladite zone semiconductrice et la couche d'isolant électrique de grille arrière (13) révélée à l'étape de gravure une couche d'isolant électrique de grille avant, au moins une couche de matériau de grille avant (14) et une couche de masquage (15),
- graver la couche de masquage pour obtenir ledit élément de masquage (17).

3. Procédé selon la revendication 2, dans lequel une couche électriquement isolante est également formée sur ladite au moins une couche de matériau de grille arrière pour servir de couche de collage, lors de la fixation du deuxième substrat sur le premier substrat, avec la face électriquement isolante du premier substrat qui est une face libre d'une couche électriquement isolante du premier substrat et formant également une couche de collage.

4. Procédé selon l'une quelconque des revendications 1 à 3, dans lequel l'étape consistant à former un motif dans la couche de matériau de grille avant comprend une étape de gravure anisotrope permettant d'éliminer le matériau de grille avant en dehors du motif, une étape de gravure isotrope permettant de réduire la longueur de la grille avant et de former des logements pour des espaceurs de grille avant sous l'élément de masquage, et une étape de formation d'espaceurs de grille avant dans lesdits logements.

5. Procédé selon la revendication 4, dans lequel la formation d'espaceurs de grille avant est réalisée par dépôt d'une couche de matériau d'espaceurs de grille avant et par gravure anisotrope de la couche de matériau d'espaceurs de grille avant.

6. Procédé selon l'une des revendications 4 ou 5, comprenant en outre les étapes consistant à :
- graver la couche d'isolant électrique de grille arrière (5) exposée après la gravure de la première partie de la zone semiconductrice,
- éliminer ladite couche de protection (21),
- graver ladite au moins une couche de matériau de grille arrière (6, 7) non masquée par les parties non gravées de la couche d'isolant électrique de grille arrière (5', 5"), jusqu'a atteindre ladite face isolante (11) du premier substrat (10),
- réduire, au moyen d'une gravure isotrope, la longueur des parties subsistantes de ladite au moins une couche de matériau de grille arrière, formant ainsi des logements pour des espaceurs de grille arrière,
- former des espaceurs de grille arrière (22) dans lesdits logements d'espaceurs de grille arrière,
- épitaxier, à partir de la partie
restante, ou deuxième partie, de la zone semiconductrice, des zones de raccordement (24') au canal du transistor pour constituer les régions de source et de drain (12").

7. Procédé selon l'une quelconque des revendications 1 à 3, dans lequel l'étape consistant à former un motif dans la couche de matériau de grille avant comprend une étape de gravure anisotrope permettant d'éliminer le matériau de grille avant en dehors du motif.

8. Procédé selon la revendication 7, comprenant en outre les étapes consistant à :
- graver la couche d'isolant électrique de grille arrière exposée après la gravure de la première partie de la zone semiconductrice,
- éliminer ladite couche de protection,
- graver ladite au moins une couche de matériau de grille arrière non masquée par les parties non gravées de la couche d'isolant électrique de grille arrière, jusqu'à atteindre ladite face isolante du premier substrat,
- réduire, au moyen d'une gravure isotrope, la longueur des parties subsistantes de ladite au moins une couche de matériau de grille avant et de ladite au moins une couche de matériau de grille arrière, formant ainsi des logements pour des espaceurs de grille avant et des logements pour des espaceurs de grille arrière,
- former des espaceurs de grille avant dans les logements d'espaceurs de grille avant et des espaceurs de grille arrière dans les logements d'espaceurs de grille arrière,
- épitaxier, à partir de la partie restante, ou deuxième partie, de la zone semiconductrice, des zones de raccordement au canal du transistor pour constituer les régions de source et de drain.

## Patentansprüche

1. Verfahren zur Herstellung mindestens einer Struktur für einen Doppelgate-Feldeffekttransistor, das die folgenden Schritte umfasst:
Ausbilden, auf einer isolierenden Fläche (11) eines ersten Substrates (10),
einer Schichtung, die aufeinanderfolgend aufweist: mindestens eine Materialschicht eines hinteren Gate (6, 7), eine elektrisch isolierende Schicht eines hinteren Gate (5), eine Halbleiterschicht je herzustellender Struktur (4), eine elektrisch isolierende Schicht eines vorderen Gate (13),
mindestens eine Materialschicht eines vorderen Gate (14) und ein Maskierelement (17), je herzustellender Struktur, das gegenüber der Halbleiterzone angeordnet ist,
Ausbilden, in der Materialschicht des vorderen Gate, eines Musters (16),
das die Form des Maskierelementes (17) wiedergibt, wobei es das Ätzen der Materialschicht des vorderen Gate umfasst, um das Material des vorderen Gate außerhalb des Musters zu eliminieren, Ausbilden, auf den freien Flächen des Musters, eines Opfer-Abstandsstückes (20), das einen ersten Teil der Halbleiterzone bedeckt,
und Eliminieren des freiliegenden Teils der elektrischen Isolierschicht des vorderen Gate, und somit An-den-Tag-Bringen des verbleibenden Teils oder zweiten Teils der Halbleiterzone, der zur Bildung der Source- und
Drain-Gebiete des Transistors bestimmt ist,
Ausbilden einer Schutzschicht (21) auf dem verbleibenden Teil oder
zweiten Teil der Halbleiterzone,
Eliminieren des Opfer-Abstandsstücks, das den ersten Teil der Halbleiterzone bedeckt,
Ätzen des ersten Teils der Halbleiterzone, die nicht mehr durch das Opfer-Abstandsstück bedeckt ist, um den Kanal (12') des Transistors zu begrenzen.

2. Verfahren nach Anspruch 1, bei dem der Schritt zur Bildung der Schichtung die folgenden Schritte umfasst:
Wählen eines zweiten Substrats (1) vom Typ Halbleiter-auf-Isolator, d. h.
eines Substrats, das einen Träger (2) aufweist, der aufeinanderfolgend eine elektrisch isolierende Schicht (3) und eine Halbleiterschicht (4) aufweist, die dazu bestimmt ist, die Halbleiterzone zu liefern, Ausbilden, auf der Halbleiterschicht (4), der elektrisch isolierenden Schicht des hinteren Gate (5) und der mindestens einen Materialschicht des hinteren Gate (6, 7),
Anbringen des zweiten Substrats auf dem ersten Substrat (10), wobei die auf dem zweiten Substrat gebildeten Schichten sich gegenüberliegend einer elektrisch isolierenden Fläche des ersten Substrates befinden,
Eliminieren des Trägers (2) und der elektrisch isolierenden Schicht (3) des zweiten Substrates, um die Halbleiterschicht (4) an den Tag zu bringen,
Ätzen der Halbleiterschicht (4), um die Halbleiterzone (12) zu erzielen und
die elektrisch isolierende Schicht des hinteren Gate an den Tag zu bringen,
aufeinanderfolgendes Ausbilden, auf der Halbleiterschicht und der elektrisch isolierenden Schicht des hinteren Gate (13), die beim Schritt des Ätzens an den Tag gebracht wurde, einer elektrisch isolierenden Schicht eines vorderen Gate, mindestens einer Materialschicht eines vorderen Gate (14), und einer Maskierschicht (15),
Ätzen der Maskierschicht, um das Maskierelement (17) zu erhalten.

3. Verfahren nach Anspruch 2, bei dem eine elektrisch isolierende Schicht ebenfalls auf der mindestens einen Materialschicht eines hinteren Gate ausgebildet wird, um als Anklebeschicht zu dienen, und zwar beim Anbringen des zweiten Substrates auf dem ersten Substrat, mit der elektrisch isolierenden Fläche des ersten Substrates, die eine freie Fläche einer elektrisch isolierenden Schicht des ersten Substrates ist und gleichermaßen eine Anklebeschicht bildet.

4. Verfahren nach einem der Ansprüche 1 bis 3, bei dem der Schritt, der darin besteht, ein Muster in der Materialschicht eines vorderen Gate auszubilden, umfasst: einen Schritt eines anisotropen Ätzens, der erlaubt, das Material des vorderen Gate außerhalb des Musters zu eliminieren, einen Schritt eines isotropen Ätzens, der erlaubt, die Länge des vorderen Gate zu verringern und Aufnahmen für Abstandsstücke des vorderen Gate unter dem Maskierelement auszubilden, und einen Schritt eines Ausbildens von Abstandsstücken des vorderen Gate in den Aufnahmen.

5. Verfahren nach Anspruch 4, bei dem die Ausbildung von Abstandsstücken des vorderen Gate durch Ablagern einer Materialschicht von Abstandsstücken des vorderen Gate und durch anisotropes Ätzen der Materialschicht von Abstandsstücken des vorderen Gate realisiert wird.

6. Verfahren nach den Ansprüchen 4 oder 5, das außerdem die folgenden Schritte umfasst:
Ätzen der elektrisch isolierenden Schicht des vorderen Gate (5), die nach dem Ätzen des ersten Teils der Halbleiterzone freiliegt,
Eliminieren der Schutzschicht (21),
Ätzen der mindestens einen Materialschicht des hinteren Gate (6, 7), die durch die nicht geätzten Teile der elektrisch isolierenden Schicht des hinteren Gate (5', 5") nicht maskiert ist, bis die isolierende Fläche (11) des ersten Substrats (10) erreicht wird,
Verringern, mittels isotropen Ätzens, der Länge der noch vorhandenen Teile der mindestens einen Materialschicht des hinteren Gate, und somit Bilden von Aufnahmen für die Abstandsstücke des hinteren Gate,
Ausbilden von Abstandsstücken des hinteren Gate (22) in den Aufnahmen für Abstandsstücke des hinteren Gate,
epitaktisches Aufwachsen, ausgehend vom verbleibenden Teil oder
zweiten Teil der Halbleiterzone, und zwar von Zonen zur Verbindung (24') mit dem Kanal des Transistors, um Source- und Drain-Gebiete (12") zu bilden.

7. Verfahren nach einem der Ansprüche 1 bis 3, bei dem der Schritt, der darin besteht, ein Muster in der Materialschicht des vorderen Gate auszubilden, einen Schritt eines anisotropen Ätzens umfasst, der erlaubt, das Material des vorderen Gate außerhalb des Musters zu eliminieren.

8. Verfahren nach Anspruch 7, das außerdem die Schritte umfasst, die im Folgenden bestehen:
Ätzen der elektrisch isolierenden Schicht des hinteren Gate, die nach dem Ätzen des ersten Teils der Halbleiterzone freiliegt,
Eliminieren der Schutzschicht,
Ätzen der mindestens einen Materialschicht des hinteren Gate, die nicht durch die nicht geätzten Teile der elektrisch isolierenden Schicht des hinteren Gate maskiert ist, bis die isolierende Fläche des ersten Substrates erreicht wird,
Reduzieren, mittels isotropen Ätzens, der Länge der noch vorhandenen Teile der mindestens einen Materialschicht des vorderen Gate und der mindestens einen Materialschicht des hinteren Gate, und somit Bilden von Aufnahmen für Abstandsstücke des vorderen Gate und von Aufnahmen für Abstandsstücke des hinteren Gate,
Ausbilden von Abstandsstücken des vorderen Gate in den Aufnahmen für Abstandsstücke des vorderen Gate und von Abstandsstücken des hinteren Gate in den Aufnahmen für Abstandsstücke des hinteren Gate,
epitaktisches Aufwachsen, ausgehend vom verbleibenden Teil oder
zweiten Teil der Halbleiterzone, und zwar von Zonen zur Verbindung mit dem Kanal des Transistors, um Source- und Drain-Gebiete zu bilden.

## Claims

1. Method for manufacturing at least one structure for a double grid field effect transistor, comprising steps consisting of:
- forming, on an isolating face (11) of a first substrate (10), a stack comprising successively at least one layer of rear grid material (6, 7), a layer of rear grid isolator (5), one semi-conducting zone for each structure to be manufactured (4), an electrically insulating layer of the front grid (13), at least one layer of front grid material (14) and a masking element (17) for each structure to be manufactured, placed facing the semi-conducting zone,
- forming in the layer of front grid material a pattern reproducing the shape of the masking element (17) and comprising etching of the layer of front grid material to eliminate the front grid material outside said pattern,
- forming on the free faces of the pattern a sacrificial spacer (20) covering a first part of the semi-conducting zone and eliminating the exposed part of the electrically insulating layer of the front grid, thus revealing the remaining part, or second part, of the semi-conducting zone, intended to form the source and drain regions of the transistor,
- forming a protective layer (20) over the remaining part, or second part, of the semi-conducting zone,
- eliminating the sacrificial spacer covering said first part of the semi-conducting zone,
- etching the first part of the semi-conducting zone, which is no longer covered by the sacrificial spacer, to delineate the channel (12') of the transistor.

2. Method according to claim 1, in which the step of forming the stack comprises steps consisting of:
- choosing a second substrate (1) of the semiconductor type on an isolator, in other words a substrate comprising a support (2) supporting successively an electrically insulating layer (3) and a semi-conducting layer (4) intended to provide said semi-conducting zone,
- forming, on said semi-conducting layer (4), said electrically insulating layer of the rear grid (5) and said at least one layer of rear grid material (6, 7),
- fixing the second substrate on the first substrate (10), said layers formed on the second substrate facing an electrically insulating face of the first substrate,
- eliminating the support (2) and the electrically insulating layer (3) for the second substrate to reveal the semi-conducting layer (4),
- etching the semi-conducting layer (4) to obtain said semi-conducting zone (12) and reveal the electrically insulating layer (5) of the rear grid,
- forming successively on said semi-conducting zone and the electrically insulating layer of the rear grid (13) revealed with the step of etching an electrically insulating layer of the front grid, at least one layer of front grid (14) and a masking layer (15),
- etching the masking layer to obtain said masking element (17).

3. Method according to claim 2, in which an electrically insulating layer is also formed on said at least one layer of rear grid material to act as a bonding layer, at the time of fixing the second substrate on the first substrate, with the electrically insulating face of the first substrate which is a free face of an electrically insulating layer for the first substrate and also forming a bonding layer.

4. Method according to any one of claims 1 to 3, in which the step consisting of forming a pattern in the layer of front grid material comprises an anisotropic etching step in order to eliminate the front grid material outside the pattern, an isotropic etching step in order to reduce the length of the front grid and forming housings for the front grid spacers under the masking element, and a step of forming the front grid spacers in said housings.

5. Method according to claim 4, in which the front grid spacers are formed by depositing a layer of front grid spacer material and by anisotropic etching of the front grid spacer material.

6. Method according to either one of claims 4 and 5, comprising also steps consisting of:
- etching the electrical insulating layer of the rear grid (5) exposed after etching the first part of the semi-conducting zone,
- eliminating said protective layer (21),
- etching said at least one layer of rear grid material (6, 7) not masked by the unetched parts of the electrical insulating layer for the rear grid (5', 5"), until said isolating face (11) of the first substrate (10) is reached,
- reducing, by means of isotropic etching, the length of the existing parts of said at least one layer of rear grid material, in this manner forming housings for the rear grid spacers,
- forming the rear grid spacers (22) in said rear grid spacer housings,
- epitaxial layering, starting with the remaining part, or second part, of the semi-conducting zone, of zones (24') for connection to the channel of the transistor so as to constitute the source and drain regions (12").

7. Method according to any one of claims 1 to 3, in which the step consisting of forming a pattern in the layer of front grid material comprises an anisotropic etching step in order to eliminate the front grid material outside the pattern.

8. Method according to claim 7, comprising also steps consisting of:
- etching the electrical insulating layer of the rear grid exposed after etching the first part of the semi-conducting zone,
- eliminating said protective layer,
- etching said at least one layer of rear grid material not masked by the unetched parts of the electrical insulating layer for the rear grid, until said isolating face of the first substrate is reached,
- reducing, by means of isotropic etching, the length of the existing parts of said at least one layer of front grid material and said at least one layer of rear grid material, in this manner forming housings for the front grid spacers and housings for the rear grid spacers,
- forming the front grid spacers in the housings for the front grid spacers and the rear grid spacers in the housings for the rear grid spacers,
- epitaxial layering, starting with the remaining part, or second part, of the semi-conducting zone, of zones for connection to the channel of the transistor so as to constitute the source and drain regions.
